# EUROPÄISCHE PATENTSCHRIFT

(11) **EP 2 906 922 B1**
(45) Veröffentlichungstag und Bekanntmachung des Hinweises auf die Patenterteilung: **19.12.2018**
(21) Anmeldenummer: 13770429.2
(22) Anmeldetag: 24.09.2013
(51) Int. Cl.: G01L 19/06, G01L 9/00, B81C 1/00, G01L 13/02, H01L 29/84

(54) **DIFFERENZDRUCKSENSOR UND VERFAHREN ZU SEINER HERSTELLUNG**
DIFFERENTIAL PRESSURE SENSOR AND METHOD FOR THE PRODUCTION THEREOF
CAPTEUR DE PRESSION DIFFÉRENTIELLE ET PROCÉDÉ DE FABRICATION DUDIT CAPTEUR DE PRESSION DIFFÉRENTIELLE

(30) Priorität: 09.10.2012 DE 102012109587
(43) Veröffentlichungstag der Anmeldung: 19.08.2015
(73) Patentinhaber: Endress+Hauser SE+Co. KG, 79689 Maulburg (DE)
(72) Erfinder: GETMAN, Igor, 79539 Lörrach (DE); LINK, Thomas, 78628 Rottweil (DE); NOMMENSEN, Peter, 78054 Villingen-Schwenningen (DE); TEIPEN, Rafael, 10407 Berlin (DE)
(74) Vertreter: Andres, Angelika Maria
(86) Internationale Anmeldenummer: PCT/EP2013/069766
(87) Internationale Veröffentlichungsnummer: WO 2014/056715

(56) Entgegenhaltungen:
- EP-A2- 2 505 548
- WO-A1-93/17440
- WO-A1-94/05986
- US-A1- 2006 272 422

## Beschreibung

Die vorliegende Erfindung betrifft einen Differenzdrucksensor und ein Verfahren zu seiner Herstellung.

Differenzdrucksensoren messen bestimmungsgemäß den Differenzdruck zwischen einem ersten Mediendruck und einem zweiten Mediendruck, wobei der Bereich des zu messenden Differenzdrucks erheblich kleiner ist als der erste bzw. der zweite Mediendruck. Dies führt zu widerstreitenden Zielgrößen beim Entwurf des Differenzdrucksensors, denn einerseits soll er einen kleinen Differenzdruck messen und andererseits großen Mediendrücken standhalten, wobei insbesondere im Falle von Fehlbedienungen, der Differenzdruck durchaus die Größenordnung des Mediendrucks erreichen kann. Ohne Schutzmaßnahmen kann eine Messmembran eines Differenzdrucksensors durch einen derart hohen Differenzdruck zerstört werden.

Als Schutzmaßnahmen sind beispielsweise Überlastmembranen bekannt, welche einen Anstieg des Differenzdrucks über einen kritischen Wert verhindert. Diese Überlastmembranen sind in ein hydraulisches Messwerk integriert, welches den ersten und zweiten Mediendruck über hydraulische Pfade, die sich jeweils von einer Trennmembrankammer, die mit einer Trennmembran überdeckt ist, zu einer Seite der Messmembran erstrecken, mittels einer Übertragungsflüssigkeit zuleitet. Die Überlastmembran ist zum Differenzdrucksensor bzw. zu dessen Messmembran parallel geschaltet. Wenn nun der Differenzdruck einen kritischen Wert übersteigt, wird die Überlastmembran so weit ausgelenkt, dass das gesamte Volumen der Übertragungsflüssigkeit in der Trennmembrankammer auf der Seite des höheren Drucks von der Überlastmembran aufgenommen wird, und die Trennmembran zur Anlage kommt. Damit ist ein weiterer Anstieg des Differenzdrucks zuverlässig verhindert. Der Einsatz von Überlastmembranen führt jedoch zwingend zu größeren Volumenhüben der Übertragungsflüssigkeit und damit - bei gleicher Leistungsfähigkeit - zu größeren Trennmembranflächen, was größere Geräteabmessungen, und höhere Kosten zur Konsequenz hat. Außerdem wird die Messwerksdynamik durch die Überlastmembran und das größere Volumen der Übertragungsflüssigkeit negativ beeinflusst.

Es sind daher Bemühungen bekannt, den Überlastschutz für die Messmembran durch Membranbetten zu realisieren. Hierbei soll sich die Messmembran bei Überschreiten eines Grenzwerts für den Überdruck zumindest in dem Maße an dem Membranbett abstützen, dass die Berstspannung der Messmembran auch bei einem weiteren Druckanstieg nicht erreicht wird.

Dafür sind insbesondere asphärische Membranbetten geeignet, welche die Biegelinie der Messmembran bei dem Grenzwert für den Überdruck approximieren.

Die Patentschrift US 4 458 537 offenbart einen kapazitiven Differenzdrucksensor mit einem asphärischen Membranbett aus Glas, welches in eine Struktur koaxialer Ringe eingebracht ist, wobei die Höhen der Ringe eine Kontur bilden, welche der Biegelinie der Messmembran entspricht.

Die Offenlegungsschrift DE 10 2009 046 229 A1 offenbart einen Drucksensor bzw. Differenzdrucksensor mit einem asphärischen Membranbett aus Glas, welches durch thermisches Einsinken geformt ist.

Die Patentschrift US 7 360 431 B2 und US 2006 272 422 A1 offenbaren einen Drucksensor bzw. Differenzdrucksensor mit einem asphärischen Membranbett, welches in Silizium oder Glas mittels Grauskalenlithographie präpariert ist.

Die Offenlegungsschrift DE 10 2010 028 773 A1 offenbart einen Drucksensor bzw. Differenzdrucksensor mit einem asphärischen Membranbett, welches in Silizium mittels Laserablation, gefolgt von einem Oxidationsschritt und einem abschließenden Ätzen präpariert ist.

JP10078366A offenbart einen resistiven Halbleiterdrucksensor mit einem gestuften Membranbett, welches in Silizium präpariert ist.

Die Patentschrift US 5 381 299 offenbart einen aus Silizium gefertigten kapazitiven Drucksensor mit einem gestuften Membranbett, welches die Biegelinie der Messmembran approximiert, wobei die Hüllkurve des Membranbetts im zentralen Bereich einen größeren Krümmungsradius aufweist als die Messmembran.

Die Veröffentlichung WO 09 317 440 A1 offenbart einen Differenzdrucksensor mit einer Messmembran aus Silizium und Gegenkörpern aus Glas, welche zum Stützen der Messmembran im Überlastfall mit einer Ausnehmung mit einer schrägen Flanke sehr geringer Steigung versehen ist.

Die Veröffentlichung EP 2 505 548 A1 offenbart einen elektroakustischen Wandler, der eine Membran und einen Membranträger mit einer Kegelfläche aufweist, wobei die Kegelfläche mittels isotropen Ätzens unter Verwendung einer Opferschicht präpariert ist.

Die genannten Drucksensoren weisen Membranbetten auf, die grundsätzlich dem genannten Zweck genügen, jedoch ist die Präparation der Membranbetten bzw. die Integration in einen Drucksensor aufwändig.

Es ist daher die Aufgabe der vorliegenden Erfindung, einen einfach herstellbaren, überlastfesten Differenzdrucksensor und ein Verfahren zu seiner Herstellung bereitzustellen.

Die Aufgabe wird erfindungsgemäß gelöst durch den Differenzdrucksensor gemäß Anspruch 1 und das Verfahren gemäß Anspruch 14.

Der erfindungsgemäße Differenzdrucksensor umfasst eine Messmembran; einen ersten Gegenkörper; einen zweiten Gegenkörper; wobei die Messmembran zwischen dem ersten und dem zweiten Gegenkörper angeordnet ist, wobei die Messmembran mit dem ersten Gegenkörper und dem zweiten Gegenkörper jeweils über eine erste isolierende Schicht unter Bildung einer ersten bzw. zweiten Druckkammer zwischen den Gegenkörpern und der Messmembran druckdicht verbunden ist, wobei der Differenzdrucksensor weiterhin einen elektrischen Wandler zum Erfassen einer druckabhängigen Auslenkung der Messmembran aufweist, wobei der erste Gegenkörper und/oder der zweite Gegenkörper Stützstellen aufweist, an welchem die Messmembran im Falle einer einseitigen Überlast zumindest teilweise anliegt, wobei die Stützstellen positionsabhängige Höhen h gegenüber einer Referenzebene aufweisen, die parallel zu einer Ebene verläuft, die durch die Messmembran aufgespannt ist, wobei ein Zentrum der Messmembran im Falle einer Überlast an der Referenzebene anliegt, wobei erfindungsgemäß die Stützstellen durch isotropes Ätzen in der ersten isolierenden Schicht gebildet sind, und die jeweilige Höhe h einer Stützstelle jeweils eine monotone Funktion einer jeweiligen minimalen Erstreckung einer Basis der Stützstelle in der Referenzebene an der Position der Höhe h der Stützstelle ist.

Die isolierende Schicht weist gemäß einer Weiterbildung der Erfindung insbesondere Siliziumoxyd auf.

In einer Weiterbildung der Erfindung weist die Messmembran einen kreisflächenförmigen auslenkbaren Bereich auf, wobei zumindest eine Stützstelle einen zur Messmembran koaxialen kreisförmigen oder kreisbogenförmigen Verlauf aufweist, wobei die Stützstelle zumindest abschnittsweise eine konstante Höhe aufweist.

In einer Weiterbildung der Erfindung weist die Messmembran einen kreisflächenförmigen auslenkbaren Bereich auf, wobei zumindest eine Stützstelle, bezogen auf eine senkrecht zur Kreisfläche durch deren Mittelpunkt verlaufende Achse einen radialen Verlauf aufweist, wobei die Stützstelle zumindest abschnittsweise eine mit der radialen Position veränderliche Höhe h aufweist.

In einer Weiterbildung der Erfindung weisen die Stützstellen in einem inneren radialen Bereich der Druckkammer einen kreisförmigen oder kreisbogenförmigen Verlauf auf.

In einer Weiterbildung der Erfindung weisen die Stützstellen in einem äußeren radialen Bereich der Druckkammer einen radialen Verlauf auf.

In einer Weiterbildung der Erfindung weist der elektrische Wandler einen kapazitiven Wandler auf, welcher mindestens eine Gegenkörperelektrode umfasst, die gegenüber Messmembran elektrisch isoliert ist, und deren Kapazität gegenüber der Messmembran von einem zu messenden Differenzdruck abhängt.

In einer Weiterbildung der Erfindung ist die mindestens eine Gegenkörperelektrode von einem ringförmigen Graben umgeben, wobei die Gegenkörperelektrode durch den Graben von einem den Graben umgebenden Teil des Gegenkörpers, elektrisch isoliert ist.

In einer Weiterbildung der Erfindung weist der Graben eine Breite auf, die mindestens das 20-fache vorzugsweise mindestens das 40-fache und besonders mindestens das 80-fache des Abstands zwischen der Gegenkörperelektrode und der Messmembran in der Ruhelage der Messmembran beträgt.

In einer Weiterbildung der Erfindung weist die Messmembran einen auslenkbaren Bereich auf, dessen Durchmesser mindestens das 200-fache, insbesondere mindestens das 400-fache und bevorzugt mindestens das 800-fache des Abstands zwischen der Messmembran in der Ruhelage und der mindestens einen Gegenkörperelektrode beträgt.

In einer Weiterbildung der Erfindung beträgt die Stärke der ersten isolierenden Schicht nicht mehr als 16 µm, insbesondere nicht mehr als 8 µm und bevorzugt nicht mehr als 4 µm.

In einer Weiterbildung der Erfindung weist der Gegenkörper eine Schichtstruktur mit einer ersten leitfähigen Schicht und einer zweiten leitfähigen Schicht auf, die durch eine zweite isolierende Schicht voneinander getrennt sind, wobei die erste leitfähige Schicht der Messmembran zugewandt ist und die Gegenkörperelektrode aufweist, wobei sich der Graben durch die erste leitfähige Schicht bis zur zweiten isolierenden Schicht erstreckt.

In einer Weiterbildung der Erfindung weist die zweite isolierende Schicht eine Stärke auf, die nicht weniger als die Stärke der ersten isolierenden Schicht beträgt, wobei die Stärke der zweiten isolierenden Schicht insbesondere nicht weniger als das Doppelte, vorzugsweise nicht weniger als das Dreifache der ersten isolierenden Schicht beträgt.

In einer Weiterbildung der Erfindung weist der Gegenkörper einen ebenen Oberflächenabschnitt auf, von dem sich die Stützstellen erheben, wobei der Oberflächenabschnitt durch den Graben begrenzt ist, wobei der Oberflächenabschnitt auf nicht mehr als 20%, insbesondere nicht mehr als 10 % und bevorzugt nicht mehr als 7,5% seiner Oberfläche Erhebungen von Stützstellen aufweist.

Das erfindungsgemäße Verfahren zum Präparieren eines Gegenkörpers für einen Differenzdrucksensor weist die folgenden Schritte auf: Bereitstellen eines zumindest abschnittsweise leitfähigen Körpers, welcher eine Deckschicht aus einem elektrisch isolierenden Werkstoff aufweist; Maskieren der Deckschicht mit einer Ätzmaske, wobei die Ätzmaske in einem zeitgesteuerten, isotropen Ätzprozess zumindest abschnittsweise unterätzt werden soll, um die Deckschicht in einem Bereich des Körpers bis auf Stützstellen mit positionsabhängigen Höhen zu entfernen, wobei die Ätzmaske Durchbrüche aufweist, durch welche eine Ätzlösung die Deckschicht angreifen kann, wobei der Abstand zwischen benachbarten Durchbrüchen, zwischen denen Stützstelle zu präparieren sind, in Abhängigkeit der angestrebten Höhe bzw. des angestrebten Höhenverlaufs der Stützstelle gegeben ist, wobei der Abstand mit zunehmender Höhe der Stützstelle ansteigt; Ätzen der Deckschicht durch die Ätzmaske hindurch; Stoppen des Ätzvorgangs nach einer vorgegebene Zeit; und Entfernen der Ätzmaske.

In einer Weiterbildung der Erfindung weisen der leitfähige Körper Silizium und die Deckschicht amorphes Siliziumdioxid auf.

In einer Weiterbildung der Erfindung weist die Maske Chrom oder einen Photolack auf, oder sie ist als Hartmaske gestaltet, insbesondere als metallische Hartmaske.

In einer Weiterbildung der Erfindung erfolgt das Ätzen mittels HF wobei HF insbesondere, reinoder verdünnt bereitgestellt wird.

In einer Weiterbildung der Erfindung umfasst das Ätzen ein Trockenchemisches Ätzverfahren, insbesondere unter Verwendung von SF₆, insbesondere RIE oder DRIE.

Die Erfindung wird nun anhand der in den Zeichnungen dargestellten Ausführungsbeispiele näher erläutert. Es zeigt:
- Fig. 1:: einen schematischen Längsschnitt durch ein Ausführungsbeispiel eines erfindungsgemäßen Differenzdrucksensors;
- Fig. 2:: eine schematische Darstellung der Schrittfolge eines Ausführungsbeispiels eines Verfahrens zur Präparation von Stützstellen auf einer Gegenkörperoberfläche.
- Fig. 3:: Darstellungen von Masken zur Präparation erfindungsgemäßer Stützstellen auf einer Gegenkörperoberfläche; und
- Fig. 4:: REM-Aufnahmen von Gegenkörperoberflächen mit Stützstellen.

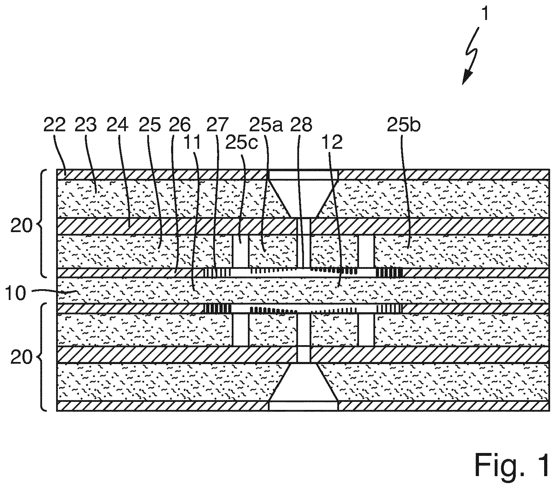

Der in Fig. 1 dargestellte Differenzdrucksensor 1 umfasst eine Messmembran 10 aus Silizium, die zwischen zwei Gegenkörpern 20 angeordnet und entlang eines ringflächenförmigen Randbereiches 11, der einen kreisscheibenförmigen, auslenkbaren Bereich 12 umgibt, mit beiden Gegenkörpern 20 druckdicht verbunden ist. Die Messmembran weist eine Stärke von einigen 10 µm auf, beispielsweise etwa 40 µm, wobei die Stärke der Messmembran im Verhältnis zum Radius des auslenkbaren Bereichs in Abhängigkeit des angestrebten Messbereichs zu wählen ist. Im vorliegenden Ausführungsbeispiel beträgt der Radius des auslenkbaren Bereichs 12 der Messmembran etwa 1100 µm.

Die beiden Gegenkörper 20 weisen vorzugsweise, bezogen auf eine Mittenebene der Messmembran, einen mikromechanisch im wesentlichen symmetrischen Aufbau auf, so dass die folgende Beschreibung der Struktur eines Gegenkörpers 20 auch für den anderen gilt. Der Gegenkörper 20 weist eine Schichtstruktur auf, deren Schichtfolgen nun von außen nach innen beschrieben wird.

Der Gegenkörper 20 weist an seiner äußeren Oberfläche eine erste Isolationsschicht 22 auf, die beispielsweise eine Stärke von einigen wenigen µm, insbesondere weniger als 5 µm, vorzugsweise 2 µm auf, welche bevorzugt SiO₂ aufweist. Die erste Isolationsschicht 22 bedeckt eine Trägerschicht 23, welche eine Stärke von einigen hundert Mikrometern, insbesondere etwa 300 µm aufweist, wobei die Trägerschicht 23 insbesondere Silizium aufweist. Der Trägerschicht 23 folgt eine zweite Isolationsschicht, 24, welche beispielsweise eine Stärke von 4 µm aufweist, und bevorzugt SiO₂ aufweist. Die zweite Isolationsschicht 24 isoliert die Trägerschicht 23 von einer Elektrodenschicht 25, welche beispielsweise eine Stärke von 50 µm aufweist und bevorzugt Si aufweist. Die Elektrodenschicht 25 weist eine zentrale Gegenkörperelektrode 25a mit einem Radius von etwa 750 µm und einen die Gegenkörperelektrode umgebenden Randbereich 25b auf, wobei die Gegenkörperelektrode 25a und der Randbereich 25b durch einen ringförmigen Graben 25c voneinander getrennt sind. Der Graben 25c weist beispielsweise eine Breite von 50 µm auf. Auf die Elektrodenschicht 25 folgt eine dritte Isolationsschicht 26, deren zentraler Bereich bis auf Stützstellen 27 weggeätzt ist. Die dritte Isolationsschicht 26 weist eine Stärke von beispielsweise 2 µm auf. Ein Randbereich der dritten Isolationsschicht 26, welcher die Stützstellen 27 ringförmig umgibt, ist druckdicht mit der Messmembran 10 verbunden, beispielsweise über Fusion-Bond, insbesondere Hochtemperatur-Fusion-Bond.

Die Stützstellen weisen zueinander einen Abstand von nicht mehr als einigen 10 µm auf, beispielsweise 20 µm bis 30 µm.

Sinn und Zweck der Stützstellen 27 ist es, die Messmembran 12 im Überlastfall abzustützen, also zu gewährleisten, dass die Messmembran ab einem bestimmten Überlastdruck an den Stützstellen anliegt, und damit eine weitere Auslenkung der Messmembran vermieden bzw. verringert wird, um damit die Zugspannungen in der Messmembran unter der Berstspannung des Werkstoffs, hier Si, zu halten.

Aus der Zielsetzung ergibt sich, dass die Stützstellen 27 einerseits hinreichend dicht gesetzt sein sollen, um bei einem zu erwartenden Überlastdruck die Spannungen unter der Berstspannung zu halten.

Die Stützstellen weisen zueinander einen Abstand von nicht mehr als einigen 10 µm auf, beispielsweise nicht mehr als 80 µm, insbesondere nicht mehr als 40 µm, vorzugsweise 20 µm bis 30 µm. Bei ringförmigen Stützstellen kann ein konstanter Abstand zwischen zwei benachbarten konzentrischen Ringen gegeben sein. Bei radial verlaufenden Stützstellen variiert der Abstand mit dem Radius.

Selbstverständlich sind auch andere Formen für die Stützstellen möglich.

Um die die Messmembran bestimmungsgemäß abstützen zu können, weisen die Stützstellen wirksame Höhen h(r) als Funktion des Radius r auf, die mit dem Radius monoton ansteigen. Die wirksamen Höhen sind die Höhen jener Bereiche der Stützstellen, an denen die Messmembran zur Anlage kommt.

Die wirksamen Höhen h(r) können beispielsweise jeweils der Höhe gemäß der Biegelinie d ·[1-(1-(r/R₀)²)²] der Messmembran entsprechen, aber auch einfachere Formen wie d ·(r/R₀) können schon eine wirksame Abstützung bieten, wobei d der Abstand zwischen dem auslenkbaren Bereich 12 der Messemembran und der zentralen Elektrode 25a ist, und R₀ den Radius des auslenkbaren Bereichs 12 der Messmembran bezeichnet. Grundsätzlich sind auch beliebige andere Funktionen h(r) geeignet, die eine übermäßige Durchbiegung der Messmembran verhindern.

Stützstellen sind insbesondere in den radialen Bereichen erwünscht, in denen hohe Spannungen bei einer Durchbiegung der Messmembran zu erwarten sind, um diese Spannungen zu begrenzen. Dies ist insbesondere am äußeren Rand des auslenkbaren Bereichs 12 der Messmembran der Fall. Insofern ist es sinnvoll, in der Nähe des Rands Stützstellen bereitzustellen. Diese Erwägung beeinflusst die Positionierung und Dimensionierung des Grabens 25c zwischen der zentralen Gegenkörperelektrode 25a und dem Randbereich 25b. Der Graben 25c begrenzt mit seinem Innenradius rᵢ einerseits die Fläche der Gegenkörperelektrode 25a und damit deren Kapazität, gegenüber der Messmembran. Andererseits dient der Graben 25c dazu, eine Streukapazität der Gegenkörperelektrode 25a zum Randbereich 25b zu verringern. Dazu ist eine Mindestgrabenbreite rₐ - rᵢ von einigen 10 µm, beispielsweise 50 µm vorteilhaft. Um dennoch die Kapazität zwischen der Messmembran 12 und der Gegenkörperelektrode nicht zu sehr zu begrenzen, würde man den Graben bei gegebener Breite rₐ - rᵢ zunächst so weit wie möglich nach außen positionieren, so dass gilt rₐ = R₀. Wobei R₀ der Radius des auslenkbaren Bereichs 12 der Messmembran ist. Entgegen dieser Erwägung ist der Graben jedoch um einige 100 µm, beispielsweise etwa 300 µm nach innen verlegt, um zwischen dem Außenradius rₐ des Grabens und dem Radius R₀ des auslenkbaren Bereichs 12 der Messmembran, noch Stützstellen 27 bereitstellen zu können, um die Messmembran 10 gerade in diesem Bereich höchster Zugspannungen im Überlastfall entlasten zu können.

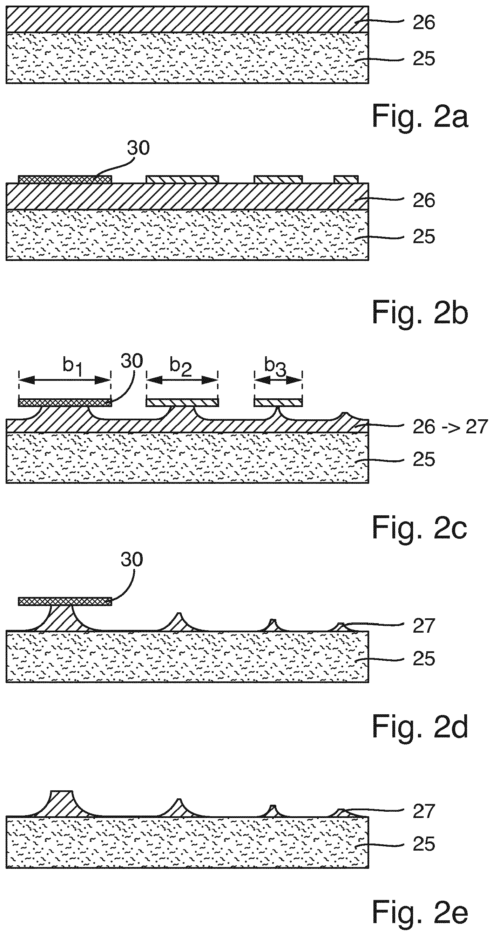

Die Präparation der Stützstellen 27 durch Ätzen von Teilen der dritten Isolationsschicht 26 wird nun schematisch anhand von Fig. 2 erläutert.

Fig. 2a zeigt einen Ausschnitt der dritten Isolationsschicht 26 auf der Elektrodenschicht 25. Auf der dritten Isolationsschicht 26 wird eine teilweise durchbrochene Ätzmaske 30 präpariert, wie in Fig. 2b dargestellt ist. Die Maske kann beispielsweise Chrom oder einen Photolack umfassen, oder aus einer Hartmaske aus Metallen wie Aluminium oder Gold präpariert sein.

In einem isotropen Ätzprozess, der in Fign. 2c und 2d dargestellt ist, wird die Maske 30 teilweise unterätzt, wobei der Ätzprozess so lange durchgeführt wird, bis die dritte Isolationsschicht 26 in jenen Bereichen, die nicht von der Maske 30 geschützt sind, bis auf die Elektrodenschicht 25 vollständig weggeätzt ist. Es bleiben nur Stützstellen 27 stehen, deren Höhen gegenüber der Oberfläche der Elektrodenschicht 25 sich aus den Breiten bᵢ (i= 1, 2, 3, ...) deckender Maskenbereiche ergeben, wie in Fig. 2c dargestellt ist. Um nämlich die dritte Oxidschicht 26 unter einem deckenden Bereich der Maske weg zu ätzen, erfolgt zunächst eine laterale Unterätzung, bis die beiden Ätzfronten in der Mitte des abgedeckten Bereichs zusammentreffen. Erst ab diesem Zeitpunkt wird die Höhe des abgedeckten Bereichs reduziert.

Da die Zeitdauer, bis die Ätzfronten beim Unterätzen zusammentreffen, von der Breite der abgedeckten Bereiche abhängt, und da die Gesamtzeit für den Ätzvorgang konstant gehalten wird, kann damit über die Breite der abgedeckten Bereiche deren verbleibende Höhe gesteuert werden.

Nach Entfernen der Ätzmaske bleiben Stützstellen 27 stehen, wie in Fig. 2e dargestellt ist.

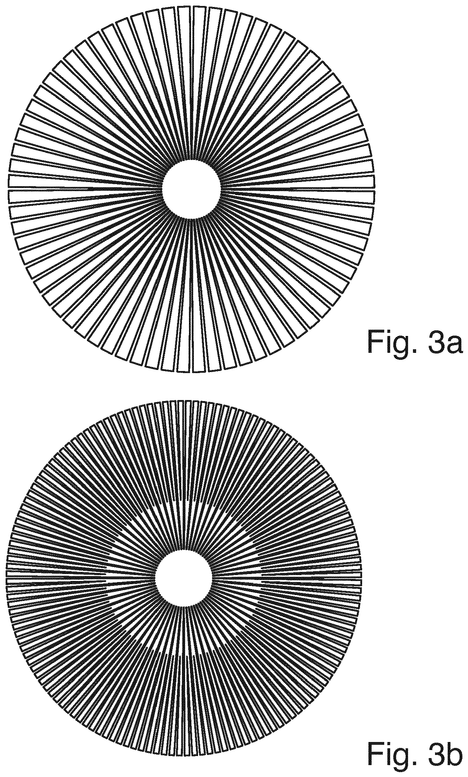

Fig. 3 zeigt Beispiele von Masken mit radial verlaufenden Maskierungsstreifen deren Breite jeweils mit dem Radius ansteigt, um Stützstellen mit einem entsprechenden Anstieg der wirksamen Höhen zu präparieren.

Hierbei unterscheiden sich die Masken in Fign. 3a und 3b dadurch, dass die einzelnen Maskierungsstreifen in Fig. 3a einen größeren Winkelbereich überdecken als jene in Fig. 3b. Dies führt - zumindest bei kleinen Radien - tendenziell zu einer zu engen Struktur.

Insbesondere dann, wenn radiale Maskierungsstreifen im Bereich größerer Radien in einer hohen Zahlendichte N/ϕ vorliegen, kann es sinnvoll sein bei kleineren Radien die Zahlendichte zu verringern, um noch ausreichende Abstände für einen definierten Ätzprozess zwischen den Maskierungsstreifen zu ermöglichen. Die Zahlendichte kann insbesondere dadurch reduziert werden, dass nur jeder zweite, dritte oder n-te Maskierungsstreifen sich bis zu kleineren Radien erstreckt, wie in Fig. 3b dargestellt ist.

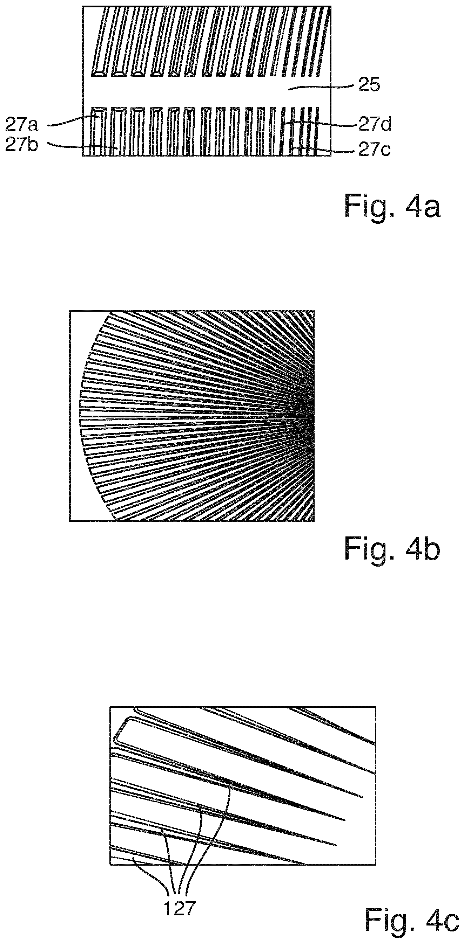

Fig. 4 zeigt schließlich REM-Aufnahmen von Stützstellen 27, 127, die durch Unterätzen in der dritten Isolationsschicht 25präpariert wurden.

Fig. 4a zeigt konzentrische Ringsegmente 27a, ... , 27d auf der Elektrodenschicht 25, wobei die Ringsegmente 27a, 27b bei großen Radien eine größere wirksame Höhe h aufweisen als die Ringsegmente 27c, 27d bei kleineren Radien. Die durch die äußeren Ringsegmente 27a, 27b gebildeten höheren Stützstellen weisen aus den zuvor beschriebenen Gründen auch eine größere Breite auf als die durch die inneren Ringsegmente 27c, 27b gebildeten niedrigeren Stützstellen. Tatsächlich ist es so dass die äußeren Ringsegmente hier sogar eine solche Bereite aufweisen, dass es bei ihrer Präparation nicht zu einer vollständigen Unterätzung gekommen ist. D. h., die äußeren Ringsegmente weisen jeweils ein Plateau konstanter Höhe auf, wobei die Höhe durch die Materialstärke der Oxydschicht vorgegeben ist.

Der gezeigte radiale Durchbruch zwischen den Ringsegmenten erleichtert die Befüllung der Kavität zwischen der Messmembran und der Elektrodenschicht mit einem Druckübertragungsmedium, beispielsweise einem Öl.

Fign. 4b und 4c zeigen radial verlaufende Stützstellen 127 in unterschiedlicher Zahlendichte N/ϕ.

## Patentansprüche

1. Differenzdrucksensor (1), umfassend:
eine Messmembran (10);
einen ersten Gegenkörper (20); und
einen zweiten Gegenkörper (20),
wobei die Messmembran (10) zwischen dem ersten und dem zweiten Gegenkörper (20) angeordnet ist
wobei die Messmembran mit dem ersten Gegenkörper (20) und dem zweiten Gegenkörper (20) jeweils über eine erste isolierende Schicht (26) unter Bildung einer ersten bzw. zweiten Druckkammer zwischen den Gegenkörpern und der Messmembran druckdicht verbunden ist, wobei die isolierende Schicht insbesondere Siliziumoxyd aufweist,
wobei der Differenzdrucksensor weiterhin einen elektrischen Wandler zum Erfassen einer druckabhängigen Auslenkung der Messmembran aufweist,
wobei der erste Gegenkörper (20) und/oder der zweite Gegenkörper (20) Stützstellen (27) aufweist, an welchem die Messmembran (10) im Falle einer einseitigen Überlast zumindest teilweise anliegt,
wobei die Stützstellen (10) positionsabhängige Höhen h gegenüber einer Referenzebene aufweisen, die parallel zu einer Ebene verläuft, die durch die Messmembran aufgespannt ist, wobei ein Zentrum der Messmembran im Falle einer Überlast an der Referenzebene anliegt,
**dadurch gekennzeichnet, dass** die Stützstellen (27) durch isotropes Ätzen in der ersten isolierenden Schicht (26) gebildet sind, und die jeweilige Höhe h einer Stützstelle jeweils eine Funktion einer Erstreckung einer Basis der Stützstelle in der Referenzebene ist, wobei die Höhe einer Stützstelle eine monotone Funktion der jeweiligen minimalen Erstreckung der Basis der Stützstelle in der Referenzebene an der Position der Höhe h der Stützstelle ist.

2. Differenzdrucksensor nach einem der vorhergehenden Ansprüche, wobei die Messmembran einen kreisflächenförmigen auslenkbaren Bereich aufweist, und wobei zumindest eine Stützstelle einen zur Messmembran koaxialen kreisförmigen oder kreisbogenförmigen Verlauf aufweist, wobei die Stützstelle zumindest abschnittsweise eine konstante Höhe aufweist.

3. Differenzdrucksensor nach einem der vorhergehenden Ansprüche, wobei die Messmembran einen kreisflächenförmigen auslenkbaren Bereich aufweist, und wobei zumindest eine Stützstelle, bezogen auf eine senkrecht zur Kreisfläche durch deren Mittelpunkt verlaufende Achse einen radialen Verlauf aufweist, wobei die Stützstelle zumindest abschnittsweise mit der radialen Position veränderliche Höhe h aufweist.

4. Differenzdrucksensor nach einem der vorhergehenden Ansprüche wobei die Stützstellen in einem inneren radialen Bereich der Druckkammer einen kreisförmigen oder kreisbogenförmigen Verlauf und / oder in einem äußeren radialen Bereich der Druckkammer einen radialen Verlauf aufweisen.

5. Differenzdrucksensor, nach einem der bisherigen Ansprüche, wobei der elektrische Wandler einen kapazitiven Wandler umfasst, welcher mindestens eine Gegenkörperelektrode umfasst, die gegenüber der Messmembran elektrisch isoliert ist, und deren Kapazität gegenüber der Messmembran von einem zu messenden Differenzdruck abhängt,

6. Differenzdrucksensor nach Anspruch 5, wobei die mindestens eine Gegenkörperelektrode von einem ringförmigen Graben umgeben ist, wobei die Gegenkörperelektrode durch den Graben von einem den Graben umgebenden Teil des Gegenkörpers, elektrisch isoliert ist.

7. Differenzdrucksensor nach Anspruch 6, wobei der Graben eine Breite aufweist, die mindestens das 20-fache vorzugsweise mindestens das 40-fache und besonders mindestens das 80-fache des Abstands zwischen der Gegenkörperelektrode und der Messmembran in der Ruhelage der Messmembran beträgt.

8. Differenzdrucksensor nach Anspruch 5, wobei die Messmembran einen auslenkbaren Bereich aufweist, dessen Durchmesser mindestens das 200-fache, insbesondere mindestens das 400-fache und bevorzugt mindestens das 800-fache des Abstands zwischen der Messmembran in der Ruhelage und der mindestens einen Gegenkörperelektrode beträgt.

9. Differenzdrucksensor nach einem der vorhergehenden Ansprüche, wobei die Stärke der ersten isolierenden Schicht nicht mehr als 16 µm, insbesondere nicht mehr als 8 µm und bevorzugt nicht mehr als 4 µm beträgt.

10. Differenzdrucksensor nach Anspruch 5 und Anspruch 6, oder einem davon abhängigen Anspruch, wobei der Gegenkörper eine Schichtstruktur mit einer ersten leitfähigen Schicht und einer zweiten leitfähigen Schicht aufweist, die durch eine zweite isolierende Schicht voneinander getrennt sind, wobei die erste leitfähige Schicht der Messmembran zugewandt ist und die Gegenkörperelektrode aufweist, wobei sich der Graben durch die erste Leitfähige Schicht bis zur zweiten isolierenden Schicht erstreckt.

11. Differenzdrucksensor nach Anspruch 10, wobei die zweite isolierende Schicht eine Stärke aufweist, die nicht weniger als die Stärke der ersten isolierenden Schicht beträgt, wobei die Stärke der zweiten isolierenden Schicht insbesondere nicht weniger als das Doppelte, vorzugsweise nicht weniger als das Dreifache der ersten isolierenden Schicht beträgt.

12. Differenzdrucksensor nach Anspruch 6 oder einem davon abhängigen Anspruch, wobei der Gegenkörper einen ebenen Oberflächenabschnitt aufweist, von dem sich die Stützstellen erheben, und der durch den Graben begrenzt ist, der Oberflächenabschnitt auf nicht mehr als 20%, insbesondere nicht mehr als 10 % und bevorzugt nicht mehr als 7,5% seiner Oberfläche Erhebungen von Stützstellen aufweist.

13. Verfahren zum Präparieren eines Gegenkörpers für einen Differenzdrucksensor, nach einem der vorhergehenden Ansprüche, wobei das Verfahren die folgenden Schritte aufweist:
Bereitstellen eines zumindest abschnittsweise leitfähigen Körpers, welcher eine Deckschicht aus einem elektrisch isolierenden Werkstoff aufweist;
Maskieren der Deckschicht mit einer Ätzmaske, wobei die Ätzmaske in einem zeitgesteuerten, isotropen Ätzprozess zumindest abschnittsweise unterätzt werden soll, um die Deckschicht in einem Bereich des Körpers bis auf Stützstellen mit positionsabhängigen Höhen zu entfernen, wobei die Ätzmaske Durchbrüche aufweist, durch welche eine Ätzlösung die Deckschicht angreifen kann, wobei der Abstand zwischen benachbarten Durchbrüchen, zwischen denen Stützstelle zu präparieren ist, in Abhängigkeit der angestrebten Höhe bzw. des angestrebten Höhenverlaufs der Stützstelle gegeben ist, wobei der Abstand mit zunehmender Höhe der Stützstelle ansteigt;
Ätzen der Deckschicht durch die Ätzmaske hindurch;
Stoppen des Ätzvorgangs nach einer vorgegebene Zeit; und
Entfernen der Ätzmaske.

14. Verfahren nach Anspruch 13, wobei der leitfähige Körper Silizium die Deckschicht amorphes Siliziumdioxid aufweisen.

15. Verfahren nach Anspruch 13 oder 14, wobei die Maske Chrom oder einen Photolack aufweist, oder als Hartmaske gestaltet ist, insbesondere als metallische Hartmaske.

16. Verfahren nach Anspruch 13, 14 oder 15, wobei das Ätzen mittels HF erfolgt, wobei HF insbesondere, rein, verdünnt oder gesputtert bereitgestellt wird.

17. Verfahren nach einem der Ansprüche 13, 14, oder 15, wobei das Ätzen ein Trockenchemisches Ätzverfahren umfasst, insbesondere RIE oder DRIE.

## Claims

1. Differential pressure sensor (1), comprising
a measuring membrane (10);
a first counter-body (20); and
a second counter-body (20),
wherein the measuring membrane (10) is arranged between the first and second counter-body (20),
wherein the measuring membrane is connected in a pressure-tight manner in each case to the first counter-body (20) and the second counter-body (20) via a first isolating layer (26) forming a first and a second pressure chamber, respectively, between the counter-bodies and the measuring membrane, wherein the isolating layer particularly comprises silicon oxide,
wherein the differential pressure sensor also has an electrical transducer to capture a pressure-dependent deflection of the measuring membrane,
wherein the first counter-body (20) and/or the second counter-body (20) have support points (27) on which the measuring membrane (10) rests at least partially in the event of an overload on one side,
wherein the support points (10) have position-dependent heights h in relation to a reference plane, which is parallel to a plane which is delimited by the measuring membrane, wherein a center of the measuring membrane rests on the reference plane in the event of an overload,
**characterized in that**
the support points (27) are formed by isotropic etching in the first isolating layer (26), and **in that** the height h of a support point is in each case a function of an extension of a base of the support point in the reference plane, wherein the height of a support point is a monotonic function of the minimum extension of the base of the support point in the reference plane at the position of height h of the support point.

2. Differential pressure sensor as claimed in one of the previous claims, wherein the measuring membrane has an area which can be deflected, in the shape of a circular surface, and wherein at least one support point presents a coaxial profile in the shape of a circle or arc in relation to the measuring membrane, wherein the support point has a constant height at least in part.

3. Differential pressure sensor as claimed in one of the previous claims, wherein the measuring membrane has an area which can be deflected, in the shape of a circular surface, and wherein at least one support point presents a radial profile in relation to an axis running perpendicular to the circular surface and passing through the middle of said surface, wherein the support point has a variable height h with the radial position at least in part.

4. Differential pressure sensor as claimed in one of the previous claims, wherein the support points present a circular or arc-shaped profile in an inner radial zone of the pressure chamber and/or have a radial profile in an outer radial area of the pressure chamber.

5. Differential pressure sensor as claimed in one of the previous claims, wherein the electric transducer comprises a capacitive transducer comprising at least a counter-body electrode which is isolated electrically in relation to the measuring membrane, and whose capacitance in relation to the measuring membrane depends on a differential pressure to be measured.

6. Differential pressure sensor as claimed in Claim 5, wherein the at least one counter-body electrode is surrounded by an annular channel, wherein the counter-body electrode is electrically isolated by the channel from a part of the counter-body surrounding the channel.

7. Differential pressure sensor as claimed in Claim 6, wherein the channel has a width which is at least 20 times, preferably at least 40 times and particularly at least 80 times the distance between the counter-body electrode and the measuring membrane in the resting position of the measuring membrane.

8. Differential pressure sensor as claimed in Claim 5, wherein the measuring membrane has an area which can be deflected the diameter of which is at least 200 times, particularly at least 400 times and preferably at least 800 times the distance between the measuring membrane in the resting position and the at least one counter-body electrode.

9. Differential pressure sensor as claimed in one of the previous claims, wherein the thickness of the first isolating layer is not more than 16 µm, particularly not more than 8 µm and preferably not more than 4 µm.

10. Differential pressure sensor as claimed in Claim 5 and Claim 6, or a dependent claim, wherein the counter-body has a layer structure with a first conductive layer and a second conductive layer, which are separated from one another by a second isolating layer, wherein the first conductive layer faces towards the measuring membrane and has the counter-body electrode, wherein the channel extends through the first conductive layer as far as the second isolating layer.

11. Differential pressure sensor as claimed in Claim 10, wherein the second isolating layer has a thickness which is not less than the thickness of the first isolating layer, wherein the thickness of the second isolating layer particularly is not less than twice, preferably not less than three times, the first isolating layer.

12. Differential pressure sensor as claimed in Claim 6, or a dependent claim, wherein the counter-body has a planar surface section from which the support points rise and which is limited by the channel, wherein no more than 20 %, particularly not more than 10 % and preferably not more than 7.5 % of the surface of said surface section features elevations for support points.

13. Procedure for preparing a counter-body for a differential pressure sensor, as claimed in one of the previous claims, wherein said procedure comprises the following steps:
Provision of a body, which is conductive at least in part, having a cover layer made from an electrically isolating material;
masking of the cover layer with an etching mask, wherein the etching mask is to be under-etched, at least in part, in a time-controlled isotropic etching process to remove the cover layer in an area of the body with the exception of support points with position-dependent heights, wherein the etching mask has openings through which an etching solution can corrode the cover layer, wherein the distance between neighboring openings between which a support point is to be prepared is defined as a function of the desired height or of the desired height profile of the support point, wherein the distance increases with the increasing height of the support point;
Etching of the cover layer through the etching mask;
Cessation of the etching process after a predefined time; and removal of the etching mask.

14. Procedure as claimed in Claim 13, wherein the conductive body features silicon and the cover layer features amorphous silicon dioxide.

15. Procedure as claimed in Claim 13 or 14, wherein the mask features chromium or a photoresist, or is designed as a hard mask, particularly as a metal hard mask.

16. Procedure as claimed in Claim 13, 14 or 15, wherein etching is performed using HF, the HF particularly provided as pure, diluted or sputtered.

17. Procedure as claimed in one of the Claims 13, 14 or 15, wherein the etching is a dry-chemical etching process, particularly RIE or DRIE.

## Revendications

1. Capteur de pression différentielle (1), comprenant
une membrane de mesure (10) ;
un premier contre-corps (20) ; et
un deuxième contre-corps (20),
capteur pour lequel la membrane de mesure (10) est disposée entre le premier et le deuxième contre-corps (20),
la membrane de mesure étant reliée de façon étanche à la pression avec le premier contre-corps (20) et le deuxième contre-corps (20) par l'intermédiaire d'une première couche isolante (26) en formant une première et une deuxième chambres de pression entre le contre-corps et la membrane de mesure, la couche isolante comportant notamment un oxyde de silicium,
le capteur de pression différentielle comprenant en outre un convertisseur électrique destiné à mesurer une déviation fonction de la pression de la membrane de mesure,
le premier contre-corps (20) et/ou le deuxième contre-corps (20) présentant des points d'appui (27), sur lesquels la membrane de mesure (10) repose au moins partiellement dans le cas d'une surcharge unilatérale,
les points d'appui (10) présentant des hauteurs h dépendant de la position par rapport à un plan de référence, qui est parallèle à un plan délimité par la membrane de mesure, un centre de la membrane de mesure reposant sur le plan de référence dans le cas d'une surcharge,
**caractérisé**
**en ce que** les points d'appui (27) sont formés par une gravure isotrope dans la première couche isolante (26), et **en ce que** la hauteur h respective d'un point d'appui est une fonction de l'extension d'une base du point d'appui dans le plan de référence, la hauteur d'un point d'appui étant une fonction monotone de l'extension minimale respective de la base du point d'appui dans le plan de référence sur la position de la hauteur h du point d'appui.

2. Capteur de pression différentielle selon l'une des revendications précédentes, pour lequel la membrane de mesure présente une zone pouvant être déviée, en forme de surface circulaire, et pour lequel au moins un point d'appui présente par rapport à la membrane de mesure une allure coaxiale en forme de cercle ou en forme d'arc de cercle, le point d'appui présentant au moins partiellement une hauteur constante.

3. Capteur de pression différentielle selon l'une des revendications précédentes, pour lequel la membrane de mesure présente une zone pouvant être déviée, en forme de surface circulaire, et pour lequel au moins un point d'appui, par rapport à un axe perpendiculaire à la surface circulaire et passant par le centre de celle-ci, présente une allure radiale, le point d'appui présentant au moins partiellement une hauteur h variable avec la position radiale.

4. Capteur de pression différentielle selon l'une des revendications précédentes, pour lequel les points d'appui présentent, dans une zone radiale intérieure de la chambre de pression, une allure en forme de cercle ou en forme d'arc de cercle et/ou, dans une zone radiale extérieure de la chambre de pression, une allure radiale.

5. Capteur de pression différentielle selon l'une des revendications précédentes, pour lequel le convertisseur électrique comprend un convertisseur capacitif, lequel comprend au moins une électrode de contre-corps, qui est isolée électriquement par rapport à la membrane de mesure, et dont la capacité par rapport à la membrane de mesure dépend d'une pression différentielle à mesurer.

6. Capteur de pression différentielle selon la revendication 5, pour lequel l'au moins une électrode de contre-corps est entourée d'une rainure annulaire, l'électrode de contre-corps étant isolée électriquement par la rainure par rapport à une partie du contre-corps entourant la rainure.

7. Capteur de pression différentielle selon la revendication 6, pour lequel la rainure présente une largeur d'au moins 20 fois, de préférence d'au moins 40 fois et particulièrement de préférence d'au moins 80 fois la distance entre l'électrode de contre-corps et la membrane de mesure, dans la position de repos de la membrane de mesure.

8. Capteur de pression différentielle selon la revendication 5, pour lequel la membrane de mesure présente une zone pouvant être déviée, dont le diamètre est d'au moins 200 fois, notamment d'au moins 400 fois et de préférence d'au moins 800 fois la distance entre la membrane de mesure dans la position de repos et l'au moins une électrode de contre-corps.

9. Capteur de pression différentielle selon l'une des revendications précédentes, pour lequel l'épaisseur de la première couche isolante n'est pas supérieure à 16 µm, notamment pas supérieure à 8 µm et de préférence pas supérieure à 4 µm.

10. Capteur de pression différentielle selon la revendication 5 et la revendication 6, ou toute revendication en dépendant, pour lequel le contre-corps présente une structure en couches avec une première couche conductrice et une deuxième couche conductrice, qui sont séparées l'une de l'autre par une deuxième couche isolante, la première couche conductrice faisant face à la membrane de mesure et comportant l'électrode de contre-corps, la rainure s'étendant à travers la première couche conductrice jusqu'à la deuxième couche isolante.

11. Capteur de pression différentielle selon la revendication 10, pour lequel la deuxième couche isolante présente une épaisseur, qui n'est pas inférieure à l'épaisseur de la première couche isolante, l'épaisseur de la deuxième couche isolante n'étant pas inférieure au double, de préférence pas inférieure au triple de la première couche isolante.

12. Capteur de pression différentielle selon la revendication 6, ou toute revendication en dépendant, pour lequel le contre-corps présente une partie de surface plane, à partir de laquelle les points d'appui s'élèvent, et qui est limitée par la rainure, la partie de surface ne présentant pas plus de 20 %, notamment pas plus de 10 % et de préférence pas plus de 7,5 % de sa surface, des bossages de points d'appui.

13. Procédé destiné à la préparation d'un contre-corps pour un capteur de pression différentielle, selon l'une des revendications précédentes, le procédé comprenant les étapes suivantes :
Mise à disposition d'un corps au moins partiellement conducteur, lequel présente une couche de recouvrement constituée d'un matériau électriquement isolant ;
Masquage de la couche de recouvrement avec un masque de gravure, ledit masque de gravure devant être sous-gravé au moins partiellement dans un procédé de gravure isotrope, commandé dans le temps, afin de supprimer la couche de recouvrement dans une zone du corps à l'exception des points d'appui présentant des hauteurs dépendantes de la position, le masque de gravure présentant des ouvertures, à travers lesquelles une solution de gravure peut attaquer la couche de recouvrement, la distance entre des ouvertures voisines, entre lesquelles un point d'appui doit être préparé, étant définie en fonction de la hauteur recherchée ou du profil de hauteur recherché pour le point d'appui, la distance augmentant à mesure que la hauteur du point d'appui augmente ;
Gravure de la couche de recouvrement à travers le masque de gravure ;
Arrêt du processus de gravure après un temps prédéfini ; et retrait du masque de gravure.

14. Procédé selon la revendication 13, pour lequel le corps conducteur contient du silicium, la couche de recouvrement un oxyde de silicium amorphe.

15. Procédé selon la revendication 13 ou 14, pour lequel le masque présente du chrome ou une laque photosensible, ou est conçu sous la forme d'un masque dur, notamment sous la forme d'un masque dur métallique.

16. Procédé selon la revendication 13, 14 ou 15, pour lequel la gravure est réalisée au moyen de HF, le HF étant notamment mis à disposition de façon pure, diluée ou pulvérisée.

17. Procédé selon la revendication 13, 14 ou 15, pour lequel la gravure comprend un procédé de gravure par voie chimique sèche, notamment RIE ou DRIE.
